# EUROPEAN PATENT SPECIFICATION

(11) **EP 3 049 889 B1**
(45) Date of publication and mention of the grant of the patent: **10.06.2020**
(21) Application number: 13894409.5
(22) Date of filing: 27.09.2013
(51) Int. Cl.: G06F 1/26, G06F 1/32, H05K 7/14

(54) **OPTIMIZING BOOT-TIME PEAK POWER CONSUMPTION FOR SERVER/RACK SYSTEMS**
OPTIMIERUNG EINES STARTZEIT-SPITZENLEISTUNGSVERBRAUCHS FÜR SERVER/RACK-SYSTEME
OPTIMISATION DE LA CONSOMMATION D'ÉNERGIE MAXIMALE DE TEMPS D'AMORÇAGE POUR DES SYSTÈMES DE SERVEUR/BÂTI

(43) Date of publication of application: 03.08.2016
(73) Proprietor: Intel Corporation, Santa Clara, CA 95054 (US)
(72) Inventor: ZHOU, Xiaohu, Shanghai 200241 (CN); LI, Yufu, Shanghai 200124 (CN)
(74) Representative: HGF Limited
(86) International application number: PCT/CN2013/084441
(87) International publication number: WO 2015/042864

(56) References cited:
- CN-A- 103 324 495
- US-A1- 2008 201 595
- US-A1- 2012 072 740
- US-A1- 2013 132 757
- US-B1- 7 479 714
- US-B1- 7 496 772

## Description

### FIELD

The present disclosure generally relates to the field of computing. More particularly, an embodiment generally relates to optimizing boot- time peak power consumption for server and/or rack systems.

### BACKGROUND

When designing the power budget for a rack system's power supply, designers account for the maximum possible power consumption, which usually happens at server boot time. The worst case is when all mounted servers in a rack are powered up or rebooted at the same time. A server's peak power consumption happens only at some specific moments during boot process and may last tens of seconds and generally no longer than minutes. As such, a rack's power supply has to be capable enough to serve this peak power moment even though such usage is infrequent and for a relatively short duration. This raises the power supply cost and makes the rarely used headroom capacity a waste of resources.

Reference is made to US 2008/0201595 A1, which discloses an intelligent power control system for intelligently controlling startup and shutdown sequences of IT equipment to reduce peak power requirements. The intelligent power control system sends an indication to power up to a power module connected to an electronic device. The system monitors the power consumption of the electronic device during startup, and determines when the electronic device has reached a peak level of power consumption. The system then powers up other devices based on the power consumption characteristics of each preceding device. The system may use similar techniques when shutting down devices or transitioning devices from a low-power state to a normal power state. Thus, the intelligent power control system establishes an order and timing for powering up or down electronic devices that improves the power consumption characteristics of the electronic devices and reduces the power requirements of the electronic devices allowing smaller, lighter, and less expensive power supplies and battery backup systems to be used.

### SUMMARY

Embodiments of the invention are set out in the appended claims. Embodiments which do not fall within the scope of the claims do not describe part of the present invention.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
Figs. 1-2 illustrate sample graphs showing power behavior of the two servers, according to some embodiments.
Figs. 3A-3C illustrate flow diagrams of methods for optimizing boot-time peak power consumption for various computing systems, according to some embodiments.
Figs. 4-6 illustrate block diagrams of embodiments of computing systems, which may be utilized to implement some embodiments discussed herein.

### DETAILED DESCRIPTION

In the following description, numerous specific details are set forth in order to provide a thorough understanding of various embodiments. However, various embodiments may be practiced without the specific details. In other instances, well-known methods, procedures, components, and circuits have not been described in detail so as not to obscure the particular embodiments. Further, various aspects of embodiments may be performed using various means, such as integrated semiconductor circuits ("hardware"), computer-readable instructions organized into one or more programs ("software"), or some combination of hardware and software. For the purposes of this disclosure reference to "logic" shall mean either hardware, software, firmware (FM), or some combination thereof.

Some embodiments provide techniques for optimizing boot-time peak power consumption for server and/or rack systems. Moreover, techniques discussed herein with reference to a "rack" system may be also applied to other types of server configurations. Also, as discussed above, when designing the power budget for a rack system's power supply (also referred to as a PSU or Power Supply Unit), designers account for the maximum possible power consumption. This in turn raises the electricity bill a server owner has to pay and the rack PSU cost, and makes the rarely used headroom capacity a waste of resources. To this end, an embodiment provides a way to lower a rack's peak power consumption without compromising each server's boot performance. This will in turn allow for the use of a lower capacity and cheaper rack PSU. Furthermore, costs may be reduced for the PSU, through power consumption reduction, and/or for rack space (especially when we consider how much can be saved in modern data centers where tens of thousands of racks are deployed).

In some embodiments, information regarding when and which BIOS (Basic Input Output System) module causes how much power consumption on each server is identified and logged/stored. Based on this information, it is determined how to coordinate among all target servers to adjust module execution sequence on each server and as a result lower the overall peak power consumption for all target servers during their respective boot process. For example, boot data may be automatically collected and the information used to compute and provide results to optimize boot sequence on target servers without human intervention. Such an approach would be highly productive and may be applied on any scale of servers with any hardware configurations, without reducing boot performance.

Moreover, certain initialization ordering during the boot process may have to be maintained, e.g., to maintain operational correctness. For example, the memory controller may need to be initialized before the memory to allow for access to the memory.

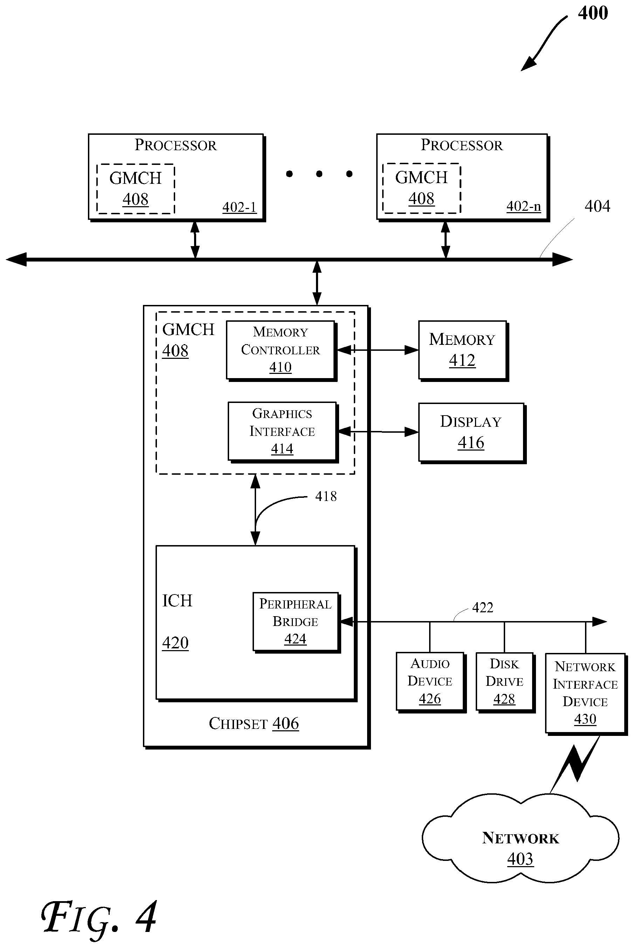

As discussed herein, a BIOS module refers to a component (such as software components/logic discussed herein with reference to various computing systems, including those of Figs. 4-6) whose execution sequence during boot time is configurable (e.g., via BIOS). Moreover, some embodiments may utilize UEFI (Unified Extensible Firmware Interface) to configure the hardware modules to cause different power consumption levels. Additionally, one or more sensors (not shown) which may be thermally proximate or thermally coupled to the module(s) may be used to detect the power consumption and timeline data discussed herein to detect the power consumption data and timeline data during the boot process.

Furthermore, while some embodiments are discussed with server/rack systems, embodiments are not limited to such high volume architectures and may be applied to smaller systems, e.g., with multiple processors or other components that use significantly more power during boot time than during runtime.

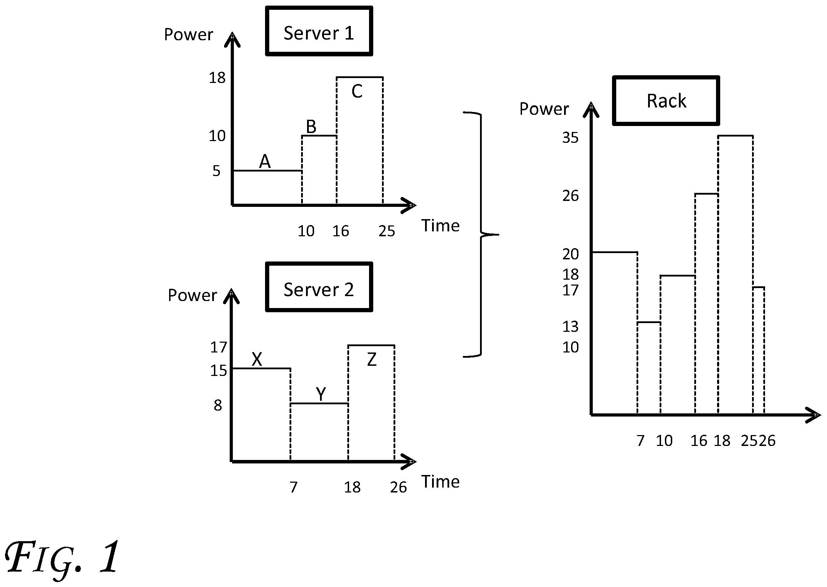

To describe details of various embodiments, assume a simplified rack system with two servers mounted (Server 1 and Server 2 shown in Figs. 1-2). Fig. 1 illustrates sample graphs showing power behavior of the two servers versus the rack without optimization, according to some implementations. Fig. 1 shows the power behavior when both servers are booting up at the same time, with the individual and summed power consumption illustrated.

Referring to Fig. 1, A, B, and C are BIOS modules on server 1, while X, Y, and Z are BIOS modules on server 2. The start and end time of module A, B, and C execution are respectively {[0, 10], [10, 16], [16, 25]}. Power consumption of modules A, B, and C is {5, 10, 18}. The start/end time of modules X, Y, Z are respectively {[0, 7], [7, 18], [18, 26]} and power consumption of modules X, Y, and Z is {15, 8, 17}.

The start/end time and power consumption of each module on each server can all be determined from a boot log. Rack power consumption is then the sum of power consumption of server 1 and server 2. So, when both servers are powering up, the rack peak power consumption occurs at [18, 25], the peak value is 18+17 =35. It is when module C on server 1 and module Z on server 2 are executed.

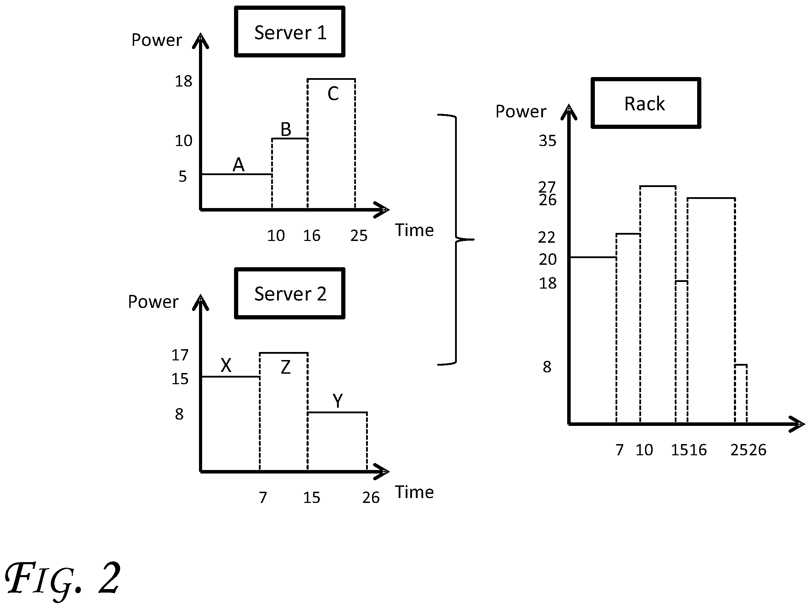

To this end, an embodiment optimizes the module execution sequence on each server. For example, in the case of Fig. 1, if we adjust module execution sequence of server 2 from X->Y->Z to X->Z->Y, then the graphs of Fig. 1 change to those of Fig. 2, which illustrate sample graphs showing power behavior of the two servers versus the rack with optimization, according to an embodiment.

As can be seen in Fig. 2, the rack peak power happens at [10, 15] when module B on server 1 and module Z on server 2 are executing, the peak value is now 10 + 17 = 27, lower down from 35 in original execution sequence of Fig. 1. Further, at rack level, we have some new time periods like [0, 7], [7, 10], [10, 15] ... etc., which may be referred to herein as "time quantum" to differentiate from original module execution time periods.

The examples of Figs. 1-2 only deal with a simplified case, whereas a more realistic scenario may involve a rack with tens of servers and each server having different hardware components (providing different BIOS modules with various duration and power consumption). To this end, the rest of the document discusses a more generalized approach to deal with more general cases.

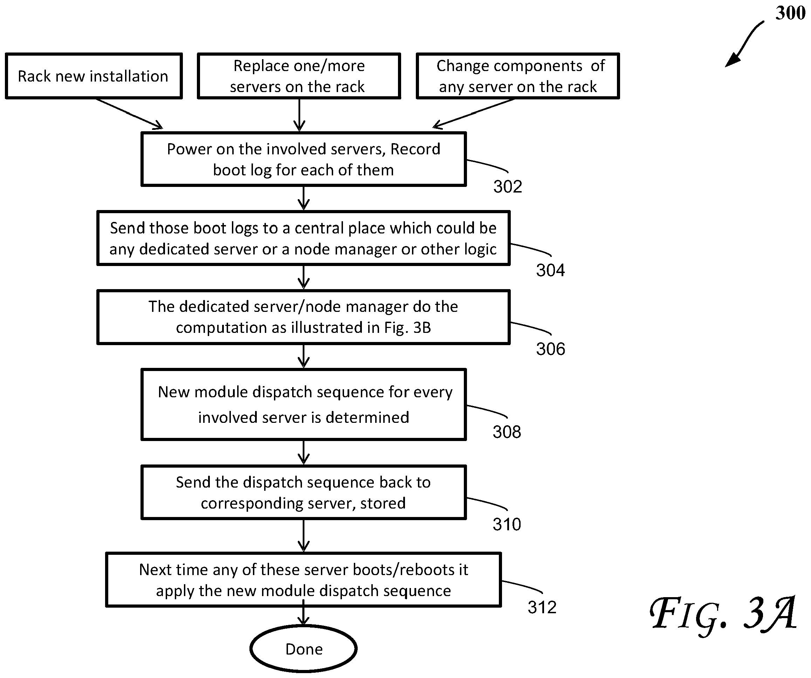

Figs. 3A-3C illustrate flow diagrams of methods for optimizing boot-time peak power consumption for various computing systems (such as server and/or rack systems), according to some embodiments. One or more components (such as processor(s), logic, and/or memory) discussed with reference to Figs. 4-6 may be utilized to perform one or more of the operations discussed with reference to Figs. 3A-3C.

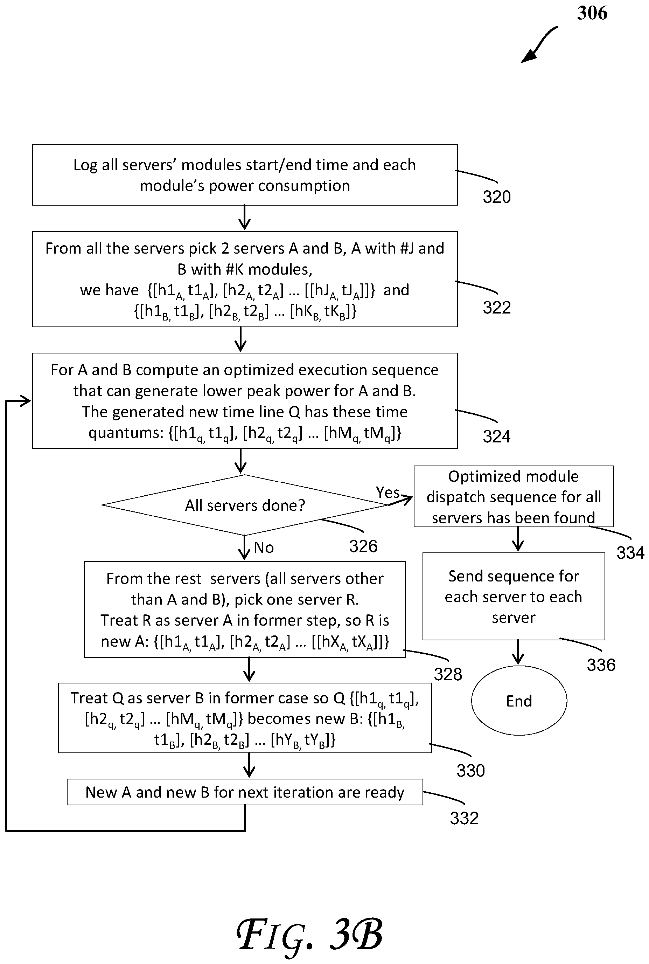

Referring to Fig. 3A, after initial system installation or upon changing/replacing a server and/or one or more components, during operation 302, the involved server(s) are powered on and the boot log(s) (such as the information discussed with reference to Figs. 1-2) stored. At an operation 304, the boot log(s) are sent to a central place which could be any dedicated server or a node manager logic (or other logic). At an operation 306, computation(s) are performed as will be further discussed with reference to Fig. 3B.

At an operation 308, a new module dispatch sequence is determined for every involved server(s) (e.g., based on the computations/determinations of operation 306). At an operation 310, each of the dispatch sequence of operation 308 is sent back to the corresponding server (and the dispatch sequence information is stored in a storage unit, which is either local to the corresponding server or otherwise accessible by the corresponding server during its boot process (such as in flash or other type of non-volatile memory)). At an operation 312, next time any of the server(s) of operation 310 boot or reboot, the new module dispatch sequence of operation 308 will be applied.

Referring to Fig. 3B, at an operation 320, start/end time information and power consumption information of each BIOS module of all involved servers (such as the information discussed with reference to Figs. 1-2) are stored. As discussed herein, start/end time of x-th server with #N module is represented as: {[h1x, t1x], [h2x, t2x]... [hNx, tNx]}.

At an operation 322, two servers A and B, are picked from all the servers, where server A has #J modules and server B has #K modules. At an operation 324, for A and B, an optimized execution sequence is computed which can generate lower peak power consumption for A and B. The generated new timeline Q has the illustrated time quantums. At an operation 326, it is determined whether all involved servers are done.

As long as all servers are not done at operation 326, at an operation 328, a server R from the rest of the servers (all servers other than A and B) is picked. Then, this new R server is treated as server A in the former operation 324 as shown in Fig. 3B at operation 328. At an operation 330, Q is treated as server B in the former case, such as shown in Fig. 3B. At an operation 332, the new A and B for the next iteration are ready and method 306 resumes at operation 324.

Once all servers are done, as determined at operation 326, an operation 334, the optimized module dispatch sequence for all servers has been found and are sent to each server at operation 336.

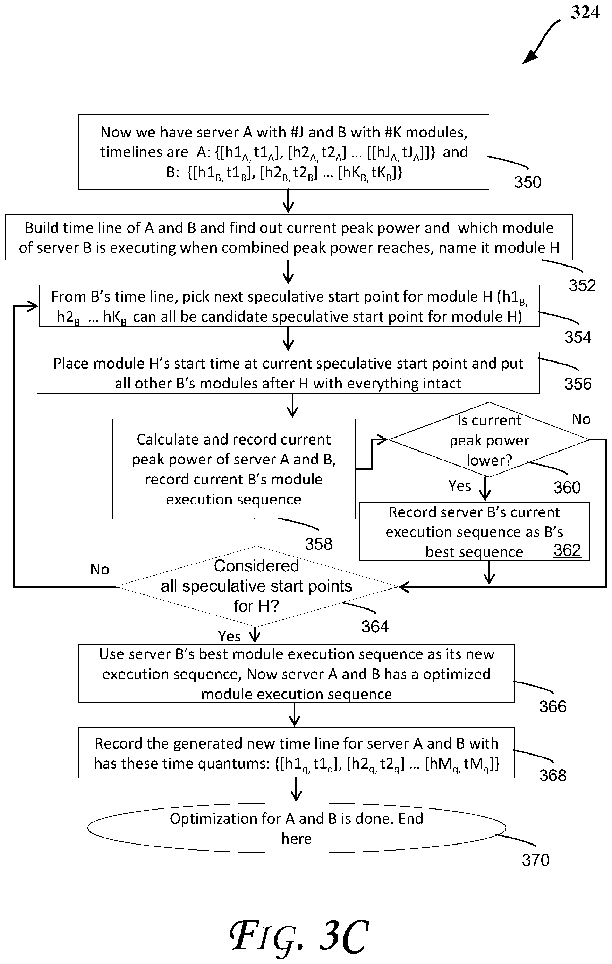

Referring to Fig. 3C (which shows details of operation 324 of Fig. 3B, in accordance with an embodiment), at an operation 350, the timelines are determine as shown in Fig. 3C in box 350. At an operation 352, the timeline for A and B are built and the current peak power is determined, indicating which module of server B is executing when combined peak power is reached (referred to as module H). After an operation 354, the next speculative start point for module H is picked from server B's timeline. At an operation 356, module H's start time is placed at the current speculative start point and all other server B's modules are put after H (without changing anything else). At an operation 358, current peak power of server A and server B are calculated and stored. Also, current B's module execution sequence is stored at operation 358.

If the current peak power is lower than any previously determined peak powers for module H (e.g., as determined at operation 360), then server B's current execution sequence is recorded as the optimal sequence for server B at an operation 362; otherwise, it is determined whether all speculative start points for H module have been considered at an operation 364. If other speculative start points remain for H module, method 324 resumes at operation 354. Otherwise, at an operation 366, server B's best module execution sequence is used as its new execution sequence (at this point server A and server B have an optimize module execution sequence). At an operation 368, the generated new timeline for servers A and B are recorded, as shown in box 368 of Fig. 3C. Have an operation 370 the optimization for servers A and B are done (and the flow transfers to operation 326 of Fig. 2B).

Fig. 4 illustrates a block diagram of a computing system 400 in accordance with an embodiment. The computing system 400 may include one or more central processing unit(s) (CPUs) 402 or processors that communicate via an interconnection network (or bus) 404. The processors 402 may include a general purpose processor, a network processor (that processes data communicated over a computer network 403), or other types of a processor (including a reduced instruction set computer (RISC) processor or a complex instruction set computer (CISC)).

Moreover, the processors 402 may have a single or multiple core design. The processors 402 with a multiple core design may integrate different types of processor cores on the same integrated circuit (IC) die. Also, the processors 402 with a multiple core design may be implemented as symmetrical or asymmetrical multiprocessors. Additionally, the operations discussed with reference to Figs. 1-3 may be performed by one or more components of the system 400. Also, various devices discussed with reference to Figs. 1-3C (such as the desktop, smartphone, tablet, UMPC (Ultra-Mobile Personal Computer), laptop computer, Ultrabook™ computing device, smart watch, smart glasses, server, rack, etc.) may include one or more of the components of Fig. 4.

For example, memory 412 may store the information discussed with reference to Figs. 1-3C and one or more of the operations discussed with reference to Figs. 1-3C may be executed on processor(s) 402. Also, system 400 may include an image capture device. Moreover, the scenes, images, or frames (e.g., which may be processed by the graphics logic in various embodiments) may be captured by the image capture device (such as a digital camera (that may be embedded in another device such as a smart phone, a tablet, a laptop, a stand-alone camera, etc.) or an analog device whose captured images are subsequently converted to digital form). Moreover, the image capture device may be capable of capturing multiple frames in an embodiment. Further, one or more of the frames in the scene are designed/generated on a computer in some embodiments. Also, one or more of the frames of the scene may be presented via a display (such as display 416, including for example a flat panel display device, etc.).

A chipset 406 may also communicate with the interconnection network 404. The chipset 406 may include a Graphics and Memory Control Hub (GMCH) 408. The GMCH 408 may include a memory controller 410 that communicates with a memory 412. The memory 412 may store data, including sequences of instructions, that may be executed by the CPU 402, or any other device included in the computing system 400. In one embodiment, the memory 412 may include one or more volatile storage (or memory) devices such as random access memory (RAM), dynamic RAM (DRAM), synchronous DRAM (SDRAM), static RAM (SRAM), or other types of storage devices. Nonvolatile memory may also be utilized such as a hard disk. Additional devices may communicate via the interconnection network 404, such as multiple CPUs and/or multiple system memories.

The GMCH 408 may also include a graphics interface 414 that communicates with a display device 416. In one embodiment, the graphics interface 414 may communicate with the display device 416 via an accelerated graphics port (AGP) or Peripheral Component Interconnect (PCI) (or PCI express (PCle) interface). In an embodiment, the display 416 (such as a flat panel display) may communicate with the graphics interface 414 through, for example, a signal converter that translates a digital representation of an image stored in a storage device such as video memory or system memory into display signals that are interpreted and displayed by the display 416. The display signals produced by the display device may pass through various control devices before being interpreted by and subsequently displayed on the display 416.

A hub interface 418 may allow the GMCH 408 and an input/output control hub (ICH) 420 to communicate. The ICH 420 may provide an interface to I/O device(s) that communicate with the computing system 400. The ICH 420 may communicate with a bus 422 through a peripheral bridge (or controller) 424, such as a peripheral component interconnect (PCI) bridge, a universal serial bus (USB) controller, or other types of peripheral bridges or controllers. The bridge 424 may provide a data path between the CPU 402 and peripheral devices. Other types of topologies may be utilized. Also, multiple buses may communicate with the ICH 420, e.g., through multiple bridges or controllers. Moreover, other peripherals in communication with the ICH 420 may include, in various embodiments, integrated drive electronics (IDE) or small computer system interface (SCSI) hard drive(s), USB port(s), a keyboard, a mouse, parallel port(s), serial port(s), floppy disk drive(s), digital output support (e.g., digital video interface (DVI)), or other devices.

The bus 422 may communicate with an audio device 426, one or more disk drive(s) 428, and a network interface device 430 (which is in communication with the computer network 403). Other devices may communicate via the bus 422. Also, various components (such as the network interface device 430) may communicate with the GMCH 408 in some embodiments. In addition, the processor 402 and the GMCH 408 may be combined to form a single chip and/or a portion or the whole of the GMCH 408 may be included in the processors 402 (instead of inclusion of GMCH 408 in the chipset 406, for example). Furthermore, the graphics accelerator 416 may be included within the GMCH 408 in other embodiments.

Furthermore, the computing system 400 may include volatile and/or nonvolatile memory (or storage). For example, nonvolatile memory may include one or more of the following: read-only memory (ROM), programmable ROM (PROM), erasable PROM (EPROM), electrically EPROM (EEPROM), a disk drive (e.g., item 428), a floppy disk, a compact disk ROM (CD-ROM), a digital versatile disk (DVD), flash memory, a magneto-optical disk, or other types of nonvolatile machine-readable media that are capable of storing electronic data (e.g., including instructions).

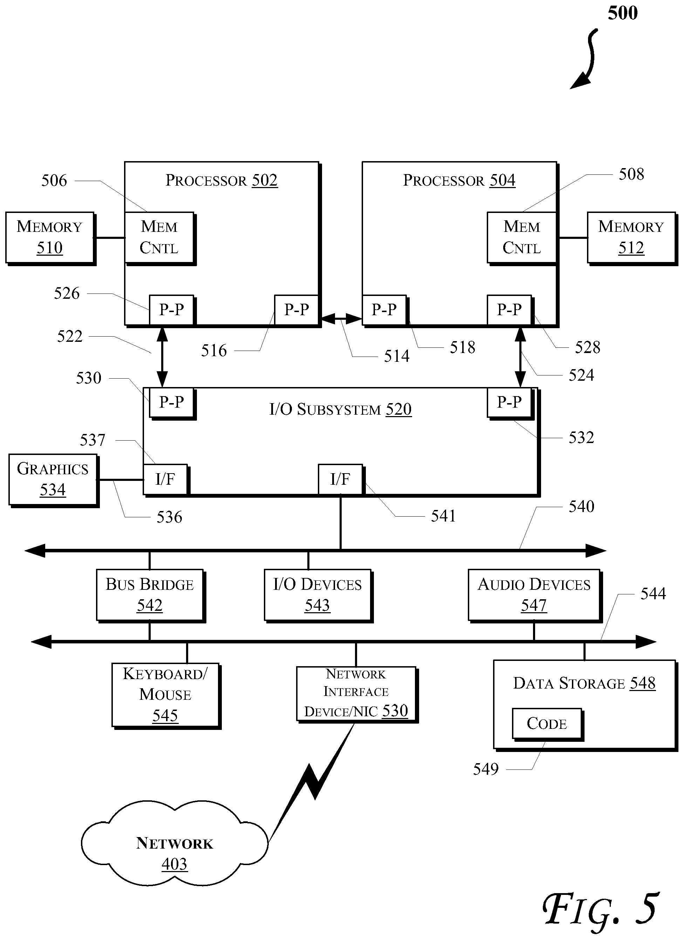

In an embodiment, components of the system 400 may be arranged in a point-to-point (PtP) configuration such as discussed with reference to Fig. 5. For example, processors, memory, and/or input/output devices may be interconnected by a number of point-to-point interfaces.

More specifically, Fig. 5 illustrates a computing system 500 that is arranged in a point-to-point (PtP) configuration, according to an embodiment. In particular, Fig. 5 shows a system where processors, memory, and input/output devices are interconnected by a number of point-to-point interfaces. The operations discussed with reference to Figs. 1-4 may be performed by one or more components of the system 500.

As illustrated in Fig. 5, the system 500 may include several processors, of which only two, processors 502 and 504 are shown for clarity. The processors 502 and 504 may each include a local memory controller hub (MCH) 506 and 508 to enable communication with memories 510 and 512. The memories 510 and/or 512 may store various data such as those discussed with reference to the memory 412 of Fig. 4.

In an embodiment, the processors 502 and 504 may be one of the processors 402 discussed with reference to Fig. 4. The processors 502 and 504 may exchange data via a point-to-point (PtP) interface 514 using PtP interface circuits 516 and 518, respectively. Also, the processors 502 and 504 may each exchange data with a chipset 520 via individual PtP interfaces 522 and 524 using point-to-point interface circuits 526, 528, 530, and 532. The chipset 520 may further exchange data with a graphics circuit 534 via a graphics interface 536, e.g., using a PtP interface circuit 537.

At least one embodiment may be provided within the processors 502 and 504. Also, the operations discussed with reference to Figs. 1-4 may be performed by one or more components of the system 500. For example, memory 510/512 may store the information discussed with reference to Figs. 1-3C and one or more of the operations discussed with reference to Figs. 1-3C may be executed on processor(s) 502/504. Also, various devices discussed with reference to Figs. 1-4 (such as the desktop, smartphone, tablet, UMPC (Ultra-Mobile Personal Computer), laptop computer, Ultrabook™ computing device, smart watch, smart glasses, server, rack, etc.) may include one or more of the components of Fig. 5.

Other embodiments, however, may exist in other circuits, logic units, or devices within the system 500 of Fig. 5. Furthermore, other embodiments may be distributed throughout several circuits, logic units, or devices illustrated in Fig. 5.

The chipset 520 may communicate with a bus 540 using a PtP interface circuit 541. The bus 540 may communicate with one or more devices, such as a bus bridge 542 and I/O devices 543. Via a bus 544, the bus bridge 542 may communicate with other devices such as a keyboard/mouse 545, communication devices 546 (such as modems, network interface devices, or other communication devices that may communicate with the computer network 403), audio I/O device 547, and/or a data storage device 548. The data storage device 548 may store code 549 that may be executed by the processors 502 and/or 504.

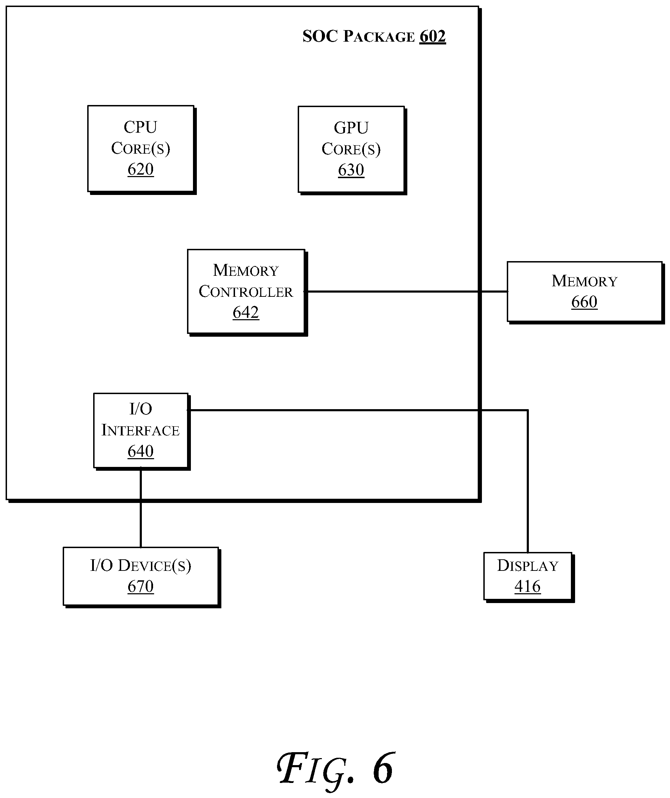

In some embodiments, one or more of the components discussed herein can be embodied as a System On Chip (SOC) device. Fig. 6 illustrates a block diagram of an SOC package in accordance with an embodiment. As illustrated in Fig. 6, SOC 602 includes one or more Central Processing Unit (CPU) cores 620, one or more Graphics Processor Unit (GPU) cores 630, an Input/Output (I/O) interface 640, and a memory controller 642. Various components of the SOC package 602 may be coupled to an interconnect or bus such as discussed herein with reference to the other figures. Also, the SOC package 602 may include more or less components, such as those discussed herein with reference to the other figures. Further, each component of the SOC package 620 may include one or more other components, e.g., as discussed with reference to the other figures herein. In one embodiment, SOC package 602 (and its components) is provided on one or more Integrated Circuit (IC) die, e.g., which are packaged into a single semiconductor device.

As illustrated in Fig. 6, SOC package 602 is coupled to a memory 660 (which may be similar to or the same as memory discussed herein with reference to the other figures) via the memory controller 642. In an embodiment, the memory 660 (or a portion of it) can be integrated on the SOC package 602.

The I/O interface 640 may be coupled to one or more I/O devices 670, e.g., via an interconnect and/or bus such as discussed herein with reference to other figures. I/O device(s) 670 may include one or more of a keyboard, a mouse, a touchpad, a display (e.g., display 416), an image/video capture device (such as a camera or camcorder/video recorder), a touch screen, a speaker, or the like.

An example includes an apparatus comprising: logic to determine a module execution sequence for a computing device to indicate a sequence of module execution during a boot process of the computing device, wherein logic to determine the module execution sequence is to determine the module execution sequence based at least partially on power consumption data and timeline data for each module of the computing device during the boot process of the computing device. According to a further example, the logic to determine the module execution sequence for the computing device is to determine a plurality of module execution sequences for a plurality of computing devices based on power consumption data and timeline data for each module of each of the plurality of the computing devices during boot process of the plurality of computing devices. According to a further example the plurality of computing devices are to be coupled via a rack system. According to a further example the module is capable of having its execution sequence modified during the boot process. According to a further example, the logic to determine the module execution sequence for the computing device is to determine the module execution sequence based on one or more speculative start points for each module of the computing device. According to a further example, the apparatus comprises one or more sensors to detect the power consumption data and timeline data during the boot process.

According to a further example, the module is capable of having its execution sequence modified during the boot process via a Basic Input Output System (BIOS). According to a further example, the module is capable of having its execution sequence modified during the boot process via a Unified Extensible Firmware Interface. According to a further example, the logic, memory, and one or more processor cores are on a single integrated circuit device.

A further example includes a method comprising: determining a module execution sequence for a computing device to indicate a sequence of module execution during a boot process of the computing device, wherein determining the module execution sequence determines the module execution sequence based at least partially on power consumption data and timeline data for each module of the computing device during the boot process of the computing device. In a further example the method further comprises determining a plurality of module execution sequences for a plurality of computing devices based on power consumption data and timeline data for each module of each of the plurality of the computing devices during boot process of the plurality of computing devices. In a further example, the plurality of computing devices are coupled via a rack system.

In various embodiments, the operations discussed herein, e.g., with reference to Figs. 1-6, may be implemented as hardware (e.g., logic circuitry), software, firmware, or combinations thereof, which may be provided as a computer program product, e.g., including a tangible (such as a non-transitory) machine-readable or computer-readable medium having stored thereon instructions (or software procedures) used to program a computer to perform a process discussed herein. The machine-readable medium may include a storage device such as those discussed with respect to Figs. 1-6 (including, for example, ROM, RAM, flash memory, hard drive, solid state drive, etc.).

Additionally, such computer-readable media may be downloaded as a computer program product, wherein the program may be transferred from a remote computer (e.g., a server) to a requesting computer (e.g., a client) by way of data signals provided in a carrier wave or other propagation medium via a communication link (e.g., a bus, a modem, or a network connection).

Reference in the specification to "one embodiment" or "an embodiment" means that a particular feature, structure, and/or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. A computing system (400) comprising a plurality of computing devices, each one comprising a plurality of modules, and an apparatus for optimizing boot-time peak power consumption of the plurality of computing devices comprising the plurality of modules, the apparatus comprising:
logic to determine (308) a module execution sequence for the plurality of computing devices and to indicate a sequence of module execution during a boot process of the plurality of computing devices,
wherein the logic to determine (308) the module execution sequence is to:
determine (320) power consumption data and timeline data for each module of each of the plurality of the computing devices during an initial boot process of the plurality of computing devices, wherein the initial boot process occurs after initial system installation, or upon changing or replacing a computing device within the system, and/or changing or replacing one or more modules of any of the computing devices within the system;
determine (360), based on the determined power consumption data and timeline data of each module, a new optimized module execution sequence for the plurality of modules of the plurality of computing devices that generates a lower peak power consumption when powering up the plurality of computing devices, and
send the determined module execution sequence to each corresponding computing device.

2. The computing system of claim 1, wherein each module is capable of having its execution sequence modified during the boot process.

3. The computing system of claim 1, wherein the logic to determine module execution sequences for the plurality of computing devices is to determine the module execution sequences based on one or more speculative start points for each module of the plurality of computing devices.

4. The computing system of claim 1, further comprising one or more sensors to detect the power consumption data and timeline data during the boot process.

5. The computing system of claim 1, wherein each module is capable of having its execution sequence modified during the boot process via a Basic Input Output System 'BIOS'.

6. The computing system of claim 1, wherein each module is capable of having its execution sequence modified during the boot process via a Unified Extensible Firmware Interface.

7. The computing system of any of claims 1 to 6, wherein the logic, a memory, and one or more processor cores are on a single integrated circuit device.

8. Apparatus for use in the computing system of claims 1 to 7.

9. A method (300) for optimizing boot-time peak power consumption of a plurality of computing devices, each one comprising a plurality of modules, the method comprising:
determining (308) a module execution sequence for the plurality of computing devices and to indicate a sequence of module execution during a boot process of the plurality of computing devices,
wherein determining the module execution sequence comprises determining (320) power consumption data and timeline data for each module of each of the plurality of the computing devices during an initial boot process of the plurality of computing devices, wherein the initial boot process occurs after initial system installation, or upon changing or replacing a computing device within the system, and/or changing or replacing one or more components of any of the computing devices within the system;
determine (360), based on the determined power consumption data and timeline data of each module, a new optimized module execution sequence for the plurality of modules of the plurality of computing devices that generates a lower peak power consumption when powering up the plurality of computing devices, and
send the determined module execution sequence to each corresponding computing device.

10. The method of claim 9, wherein each module is capable of having its execution sequence modified during the boot process.

11. The method of claim 9, wherein determining module execution sequences for the plurality of computing devices is based on one or more speculative start points for each module of the plurality of computing devices.

12. The method of claim 9, further comprising modifying the execution sequence of each module during the boot process via a Basic Input Output System 'BIOS'.

13. The method of claim 9, further comprising modifying the execution sequence of each module during the boot process via a Unified Extensible Firmware Interface.

14. Machine-readable storage including machine-readable instructions, when executed on a computer, causes the computer to implement a method as claimed in any preceding claims 9-13.

## Patentansprüche

1. Rechensystem (400), mehrere Rechengeräte umfassend, von denen jedes mehrere Module umfasst, und eine Vorrichtung zum Optimieren des Bootzeit-Spitzenenergieverbrauchs der mehreren Rechengeräte, welche die mehreren Module umfassen, wobei die Vorrichtung Folgendes umfasst:
Logik zum Bestimmen (308) einer Modulausführungsabfolge für die mehreren Rechengeräte und zum Angeben einer Abfolge der Modulausführung während eines Bootprozesses der mehreren Rechengeräte,
wobei die Logik zum Bestimmen (308) der Modulausführungsabfolge für Folgendes vorgesehen ist:
Bestimmen (320) von Energieverbrauchsdaten und Zeitachsendaten für jedes Modul jedes der mehreren Rechengeräte während eines anfänglichen Bootprozesses, wobei der anfängliche Bootprozess nach der anfänglichen Installation des Systems oder nach dem Wechseln oder Austauschen eines Rechengeräts innerhalb des Systems und/oder dem Wechseln oder Austauschen eines oder mehrerer Module von einem der Rechengeräte innerhalb des Systems erfolgt,
Bestimmen (360) einer neuen optimierten Modulausführungsabfolge für die mehreren Module der mehreren Rechengeräte, die einen geringeren Spitzenenergieverbrauch erzeugt, wenn die mehreren Rechengeräte eingeschaltet werden, basierend auf den bestimmten Energieverbrauchsdaten und Zeitachsendaten jedes Moduls, und
Senden der bestimmten Modulausführungsabfolge an jedes entsprechende Rechengerät.

2. Rechensystem nach Anspruch 1, wobei jedes Modul geeignet ist, seine Ausführungsabfolge während des Bootprozesses modifiziert zu bekommen.

3. Rechensystem nach Anspruch 1, wobei die Logik zum Bestimmen von Modulausführungsabfolgen für die mehreren Rechengeräte dafür vorgesehen ist, die Modulausführungsabfolge basierend auf einem oder mehreren spekulativen Ausgangspunkten für jedes Modul der mehreren Rechengeräte zu bestimmen.

4. Rechensystem nach Anspruch 1, ferner einen oder mehrere Sensoren zum Erkennen der Energieverbrauchsdaten und Zeitachsendaten während des Bootprozesses umfassend.

5. Rechensystem nach Anspruch 1, wobei jedes Modul in der Lage ist, seine Ausführungsabfolge während des Bootprozesses über ein BIOS (Basic Input Output System) modifiziert zu bekommen.

6. Rechensystem nach Anspruch 1, wobei jedes Modul in der Lage ist, seine Ausführungsabfolge während des Bootprozesses über eine Unified Extensible Firmware Interface modifiziert zu bekommen.

7. Rechensystem nach einem der Ansprüche 1 bis 6, wobei sich die Logik, ein Speicher und ein oder mehrere Prozessorkerne auf einem einzelnen integrierten Schaltungsgerät befinden.

8. Vorrichtung zur Verwendung in dem Rechensystem nach einem der Ansprüche 1 bis 7.

9. Verfahren (300) zum Optimieren des Bootzeit-Spitzenenergieverbrauchs mehrerer Rechengeräte, die jeweils mehrere Module umfassen, wobei das Verfahren Folgendes umfasst:
Bestimmen (308) einer Modulausführungsabfolge für die mehreren Rechengeräte und zum Angeben einer Abfolge der Modulausführung während eines Bootprozesses der mehreren Rechengeräte,
wobei das Bestimmen der Modulausführungsabfolge das Bestimmen (320) von Energieverbrauchsdaten und Zeitachsendaten für jedes Modul jedes der mehreren Rechengeräte während eines anfänglichen Bootprozesses der mehreren Rechengeräte umfasst, wobei der anfängliche Bootprozess nach der anfänglichen Installation des Systems oder nach dem Wechseln oder Austauschen eines Rechengeräts innerhalb des Systems und/oder dem Wechseln oder Austauschen einer oder mehrerer Komponenten von einem der Rechengeräte innerhalb des Systems erfolgt,
Bestimmen (360) einer neuen optimierten Modulausführungsabfolge für die mehreren Module der mehreren Rechengeräte, die einen geringeren Spitzenenergieverbrauch erzeugt, wenn die mehreren Rechengeräte eingeschaltet werden, basierend auf den bestimmten Energieverbrauchsdaten und Zeitachsendaten jedes Moduls, und
Senden der bestimmten Modulausführungsabfolge an jedes entsprechende Rechengerät.

10. Verfahren nach Anspruch 9, wobei jedes Modul in der Lage ist, seine Ausführungsabfolge während des Bootprozesses modifiziert zu bekommen.

11. Verfahren nach Anspruch 9, wobei das Bestimmen von Modulausführungsabfolgen für die mehreren Rechengeräte auf einem oder mehreren spekulativen Ausgangspunkten für jedes Modul der mehreren Rechengeräte basiert.

12. Verfahren nach Anspruch 9, ferner das Modifizieren der Ausführungsabfolge jedes Moduls während des Bootprozesses über ein BIOS (Basic Input Output System) umfassend.

13. Verfahren nach Anspruch 9, ferner das Modifizieren der Ausführungsabfolge jedes Moduls während des Bootprozesses über eine Unified Extensible Firmware Interface umfassend.

14. Maschinenlesbarer Speicher, der maschinenlesbare Befehle beinhaltet, die bei Ausführung auf einem Computer den Computer veranlassen, ein Verfahren nach einem der vorhergehenden Ansprüche 9 bis 13 umzusetzen.

## Revendications

1. Système informatique (400) comprenant une pluralité de dispositifs informatiques, comprenant chacun une pluralité de modules, et un appareil d'optimisation de consommation de puissance maximale à l'amorçage de la pluralité de dispositifs informatiques comprenant la pluralité de modules, l'appareil comprenant :
une logique pour déterminer (308) une séquence d'exécution de modules pour la pluralité de dispositifs informatiques et indiquer une séquence d'exécution de modules durant un processus d'amorçage de la pluralité de dispositifs informatiques,
dans lequel la logique pour déterminer (308) la séquence d'exécution de modules sert à :
déterminer (320) des données de consommation de puissance et des données chronologiques pour chaque module de chacun de la pluralité des dispositifs informatiques durant un processus d'amorçage initial de la pluralité de dispositifs informatiques, dans lequel le processus d'amorçage initial se produit après une installation initiale du système, et lors d'un changement ou remplacement d'un dispositif informatique dans le système, et/ou d'un changement ou remplacement d'un ou de plusieurs modules de l'un quelconque des dispositifs informatiques dans le système ;
déterminer (360), sur la base des données de consommation de puissance et des données chronologiques déterminées de chaque module, une nouvelle séquence d'exécution de modules optimisée pour la pluralité de modules de la pluralité de dispositifs informatiques qui génère une consommation de puissance maximale inférieure lors de la mise sous tension de la pluralité de dispositifs informatiques, et
envoyer la séquence d'exécution de modules déterminée à chaque dispositif informatique correspondant.

2. Système informatique selon la revendication 1, dans lequel la séquence d'exécution de chaque module peut être modifiée durant le processus d'amorçage.

3. Système informatique selon la revendication 1, dans lequel la logique pour déterminer des séquences d'exécution de modules pour la pluralité de dispositifs informatiques sert à déterminer les séquences d'exécution de modules sur la base d'un ou plusieurs points de départ spéculatifs pour chaque module de la pluralité de dispositifs informatiques.

4. Système informatique selon la revendication 1, comprenant en outre un ou plusieurs capteurs pour détecter les données de consommation de puissance et les données chronologiques durant le processus d'amorçage.

5. Système informatique selon la revendication 1, dans lequel la séquence d'exécution de chaque module peut être modifiée durant le processus d'amorçage par le biais d'un système d'entrée/sortie de base 'BIOS'.

6. Système informatique selon la revendication 1, dans lequel la séquence d'exécution de chaque module peut être modifiée durant le processus d'amorçage par le biais d'une interface micrologicielle extensible unifiée.

7. Système informatique selon l'une quelconque des revendications 1 à 6, dans lequel la logique, une mémoire, et un ou plusieurs cœurs de processeurs sont implantés sur un même dispositif à circuit intégré.

8. Appareil destiné à être utilisé dans le système informatique selon les revendications 1 à 7.

9. Procédé (300) d'optimisation de la consommation de puissance maximale à l'amorçage d'une pluralité de dispositifs informatiques, comprenant chacun une pluralité de modules, le module comprenant :
la détermination (308) d'une séquence d'exécution de modules pour la pluralité de dispositifs informatiques et pour indiquer une séquence d'exécution de modules durant un processus d'amorçage de la pluralité de dispositifs informatiques,
dans lequel la détermination de la séquence d'exécution de modules comprend la détermination (320) de données de consommation de puissance et de données chronologiques pour chaque module de chacun de la pluralité des dispositifs informatiques durant un processus d'amorçage initial de la pluralité de dispositifs informatiques, dans lequel le processus d'amorçage initial se produit après une installation initiale du système, et lors d'un changement ou remplacement d'un dispositif informatique dans le système, et/ou d'un changement ou remplacement d'un ou de plusieurs modules de l'un quelconque des dispositifs informatiques dans le système ;
la détermination (360), sur la base des données de consommation de puissance et des données chronologiques déterminées de chaque module, une nouvelle séquence d'exécution de modules optimisée pour la pluralité de modules de la pluralité de dispositifs informatiques qui génère une consommation de puissance maximale inférieure lors de la mise sous tension de la pluralité de dispositifs informatiques, et
l'envoi la séquence d'exécution de modules déterminée à chaque dispositif informatique correspondant.

10. Procédé selon la revendication 9, dans lequel la séquence d'exécution de chaque module peut être modifiée durant le processus d'amorçage.

11. Procédé selon la revendication 9, dans lequel la détermination des séquences d'exécution de modules pour la pluralité de dispositifs informatiques est basée sur un ou plusieurs points de départ spéculatifs pour chaque module de la pluralité de dispositifs informatiques.

12. Procédé selon la revendication 9, comprenant en outre la modification de la séquence d'exécution de chaque module durant le processus d'amorçage par le biais d'un système d'entrée/sortie de base 'BIOS'.

13. Procédé selon la revendication 9, comprenant en outre la modification de la séquence d'exécution de chaque module durant le processus d'amorçage par le biais d'une interface micrologicielle extensible unifiée.

14. Mémoire lisible par machine comportant des instructions lisibles par machine, qui, à leur exécution sur un ordinateur, amènent l'ordinateur à mettre en œuvre un procédé selon n'importe quelle revendication précédente 9 à 13.
